# EUROPÄISCHE PATENTANMELDUNG

(11) **EP 3 686 315 A1**
(43) Veröffentlichungstag der Anmeldung: **29.07.2020**
(21) Anmeldenummer: 20153823.8
(22) Anmeldetag: 27.01.2020
(51) Int. Cl.: C23C 14/50, C23C 14/54, C23C 14/56

(54) **VORRICHTUNG ZUM BESCHICHTEN EINES BANDFÖRMIGEN SUBSTRATES**

(30) Priorität: 28.01.2019 DE 102019102008
(71) Anmelder: FRAUNHOFER-GESELLSCHAFT zur Förderung der angewandten Forschung e.V., 80686 München (DE)
(72) Erfinder: RETHBERG, Sebastian, 01277 Dresden (DE); KÜHNEL, Thomas, 01277 Dresden (DE); STRAACH, Steffen, 01277 Dresden (DE)

(57) **Zusammenfassung**

Die Erfindung betrifft eine Vorrichtung zum Beschichten eines bandförmigen Substrates (12; 22) innerhalb einer Vakuumkammer (10; 20), umfassend eine Beschichtungseinrichtung (11); eine Kühleinrichtung mit zumindest einem konvexen Oberflächenbereich, welchen das bandförmige Substrat (12; 22) zum Zeitpunkt des Beschichtens zumindest teilweise berührt sowie ein Wickelwerk, mindestens bestehend aus einer Vorratsrolle (13; 23), einer Aufnahmerolle (15; 25) und mehreren Umlenkrollen (14; 24), wobei das bandförmige Substrat (12; 22) zumindest an der Seite, mit welcher das bandförmige Substrat (12; 22) die Kühleinrichtung berührt, aus einem elektrisch leitfähigen Material besteht, wobei
a) die Kühleinrichtung einen elektrisch leitfähigen Grundkörper (16a; 26a) und zumindest im konvexen Oberflächenbereich eine äußere Randschicht (16b; 26b) aus einem elektrisch isolierenden Material aufweist;
b) das Wickelwerk potenzialfrei bezüglich der elektrischen Masse der Vorrichtung ausgebildet ist und
c) eine elektrische Spannung von mindestens 10 V zwischen dem elektrisch leitfähigen Grundkörper (16a; 26a), der Kühleinrichtung und dem elektrisch leitfähigen Material des Substrates (12; 22) ausgebildet ist.

## Beschreibung

Die Erfindung betrifft eine Vorrichtung zum Beschichten von bandförmigen Substraten innerhalb einer Vakuumkammer, wobei das bandförmige Substrat während des Beschichtungsvorgangs gekühlt wird.

Beim Beschichten von bandförmigen Substraten im Vakuum kann es durch den Energieeintrag, der während des Beschichtens auf das bandförmige Substrat einwirkt, sehr leicht zu einer irreversiblen Verformung des Substrates kommen. Eine solche Verformung, infolge einer Überhitzung des bandförmigen Substrates, kann beispielsweise durch eine chemische Veränderung des Substratmaterials oder auch durch eine Faltenbildung oder durch plastisches Überstrecken des Substrates verursacht werden. Eine effektive Kühlung des bandförmigen Substrates kann dazu beitragen, die benannten Probleme zu lösen bzw. zu verhindern.

Üblicherweise wird ein zu beschichtendes bandförmiges Substrat von einer Vorratsrolle kontinuierlich abgerollt und abschließend auf eine andere Rolle, die sogenannte Aufnahmerolle, kontinuierlich wieder aufgewickelt. Das zu beschichtende bandförmige Substrat durchläuft während dieses Wickelvorgangs einen oder mehrere Bereiche, in denen eine Beschichtung stattfindet. Diese Beschichtung kann beispielsweise durch Kathodenzerstäuben oder einen Verdampfungsprozess realisiert werden.

Eine wichtige Gruppe von bandförmigen Substraten, die im Vakuum beschichtet werden, sind Kunststofffolien. Üblicherweise werden Kunststofffolien während eines Beschichtungsvorgangs über mindestens eine Kühlwalze geführt, welche aus einem metallenen Material besteht. Dabei werden sie durch zwei wesentliche Mechanismen gekühlt: Zum einen durch einen direkten Kontakt zwischen der Kunststofffolie und der Kühlwalze, welcher mittels des Bandzuges am Substrat und dem daraus resultierenden Anpressdruck an die Kühlwalze nur in einem begrenzten Rahmen variiert werden kann, und zum anderen durch einen Wärmetransfer über Wassermoleküle, die aus der Kunststofffolie ausdampfen und dann zwischen der Kunststofffolie und der Kühlwalze eingeschlossen sind.

Es ist bekannt, dass bei der überwiegenden Anzahl der Beschichtungsprozesse von Kunststofffolien der zweite der beiden genannten Kühlmechanismen dominiert und erst durch diesen Kühlmechanismus eine für die Durchführbarkeit des Prozesses ausreichende Kühlung gewährleistet ist. Problematisch ist das Beschichten von Kunststofffolien deshalb insbesondere dann, wenn die Kunststofffolie nach einem Beschichtungsvorgang noch nachfolgende Beschichtungsstationen durchläuft aber dann nicht mehr genügend Wassermoleküle in der Kunststofffolie vorhanden sind, die ausdampfen und einen Wärmekontakt zwischen Kunststofffolie und Kühleinrichtung herstellen können. Die gleiche Problematik besteht bei wasserarmen Kunststofffolien, wie z.B. aus Cycloolefin-Polymer (COP), schon bei einem ersten Beschichtungsvorgang, wie auch bei bandförmigen Substraten aus Metall oder Glas.

Aus dem Stand der Technik sind verschiedene Ansätze bekannt, um dieses technische Problem zu lösen. In US 5 076 203 A wird beispielsweise ein Gas direkt an der Stelle eingelassen, an der die Kunststofffolie die Kühlwalze berührt.

Eine ähnliche Lösung ist in DE 10 2013 212 395 A1 beschrieben. Hier wird zunächst Wasserdampf auf die Kühlwalze aufgesprüht, wobei die Kühlwalze soweit gekühlt wird, dass der Wasserdampf in den festen Aggregatzustand übergeht und somit eine Eisschicht zwischen Kühlwalze und einer zu beschichtenden Kunststofffolie ausgebildet wird. Während des Beschichtungsvorgangs geht diese Eisschicht aufgrund des Wärmeeintrags durch die Beschichtungseinrichtung in den flüssigen bzw. gasförmigen Zustand über und gewährleistet dann einen Wärmeübergang zwischen Kühlwalze und Kunststofffolie. Nachteilig wirkt sich bei den beiden zuvor genannten Lösungen aus, dass das in die Vakuumkammer eingelassene Gas bzw. der eingelassene Wasserdampf die Prozessatmosphäre innerhalb der Vakuumkammer negativ beeinflussen kann.

In DE 10 2012 013 726 A1 wird vorgeschlagen, ein Fluid zum Kühlen eines bandförmigen Substrates durch die konvexe Wandung einer Kühleinrichtung hindurch, zwischen einem bandförmigen Substrat und der Kühleinrichtung einzulassen. Eine derartige Vorrichtung ist jedoch technisch sehr aufwändig.

Des Weiteren sind Verfahren bekannt, bei denen eine entscheidende Erhöhung des Anpressdruckes eines bandförmigen Substrates an eine Kühlwalze mittels einer Coulombkraft durch eine elektrostatische Aufladung des bandförmigen Substrates gegenüber der Kühlwalze erreicht werden.

In EP 1 870 488 A1 wird zum Beispiel vorgeschlagen, den Aufladungszustand einer Folie zu messen und anschließend gezielt einzustellen. Nach dem Beschichtungsprozess erfolgt dann eine Entladung der Folie. Eine ähnliche Vorgehensweise ist aus EP 2 073 249 A1 bekannt. Hier wird eine lineare Elektronenquelle verwendet, um ein zu beschichtendes bandförmiges Substrat elektrisch aufzuladen. Dabei kann über die Elektronenenergie die Eindringtiefe der Elektronen in das bandförmige Substrat festgelegt werden. Die elektrostatische Aufladung eines bandförmigen Substrates kann zu einer deutlichen Erhöhung des Anpressdruckes an eine Kühlwalze führen und damit Beschichtungsprozesse im Vakuum effektiv verbessern. Nachteilig wirkt sich jedoch aus, dass eine Anpressdruckerhöhung infolge einer elektrostatischen Aufladung von bandförmigen Substraten nicht bei metallenen Folien und Bändern und bei Kunststofffolien angewendet werden kann, welche auf der Seite, die der Kühlwalze zugewandt ist (nachfolgend auch als Rückseite eines Substrates benannt), eine elektrisch leitfähige Beschichtung aufweist. Bei diesen Anwendungsfällen werden die durch eine elektrische Aufladung entstehenden Potenzialunterschiede zwischen dem bandförmigen Substrat und der Kühlwalze kurzgeschlossen. Infolgedessen fließen die Ladungen ab, wodurch die Grundlage für die Ausbildung einer Coulombkraft nicht mehr gegeben ist.

Der Erfindung liegt daher das technische Problem zugrunde, eine Vorrichtung zum Beschichten eines bandförmigen Substrates zu schaffen, mittels der die Nachteile aus dem Stand der Technik überwunden werden können. Insbesondere sollen mit der erfindungsgemäßen Vorrichtung ein verbesserter Kühleffekt und eine geringere Tendenz zur Faltenbildung während des Beschichtens auch bei metallenen bandförmigen Substraten und auch bei Kunststofffolien mit einer elektrisch leitfähigen Beschichtung auf der Rückseite erzielbar sein.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Ansprüchen.

Eine erfindungsgemäße Vorrichtung zum Beschichten eines bandförmigen Substrates innerhalb einer Vakuumkammer, umfasst eine Beschichtungseinrichtung, welche beispielsweise als Magnetronsputtereinrichtung oder als Verdampfungseinrichtung ausgebildet sein kann; eine Kühleinrichtung mit zumindest einem konvexen Oberflächenbereich, welchen das bandförmige Substrat zum Zeitpunkt des Beschichtens zumindest teilweise berührt sowie ein Wickelwerk, welches zumindest aus einer Vorratsrolle, einer Aufnahmerolle und mehreren Umlenkrollen besteht. Eine erfindungsgemäße Vorrichtung ist insbesondere zum Beschichten von bandförmigen Substraten geeignet, die zumindest an der Seite, mit welcher das bandförmige Substrat die Kühleinrichtung berührt, aus einem elektrisch leitfähigen Material besteht. Mit einer solchen Vorrichtung können somit sowohl Metallbänder als auch Kunststofffolien beschichtet werden, die bereits auf der Rückseite eine elektrisch leitfähige Beschichtung aufweisen.

Eine erfindungsgemäße Vorrichtung zeichnet sich ferner dadurch aus, dass bei dieser die Kühleinrichtung, welche beispielsweise als konvexe Formschulter oder bevorzugt als Kühlwalze ausgebildet sein kann, einen elektrisch leitfähigen Grundkörper und zumindest im konvexen Oberflächenbereich eine äußere Randschicht aus einem elektrisch isolierenden Material aufweist. Wesentlich für eine erfindungsgemäße Vorrichtung ist ebenfalls, dass zumindest die Rollen und Bestandteile des Wickelwerkes, welche mit der Rückseite eines zu beschichtenden bandförmigen Substrates in Kontakt gelangen, keine elektrisch leitfähige Verbindung zur elektrischen Masse der Vorrichtung aufweisen und somit potenzialfrei bezüglich der elektrischen Masse der Vorrichtung ausgebildet sind. Bei einer Ausführungsform ist deshalb das gesamte Wickelwerk potenzialfrei bezüglich der elektrischen Masse der Vorrichtung. Des Weiteren ist bei einer erfindungsgemäßen Vorrichtung eine elektrische Spannung von mindestens 10 V zwischen dem elektrisch leitfähigen Grundkörper der Kühleinrichtung und dem elektrisch leitfähigen Material des Substrates ausgebildet, wobei der elektrisch leitfähige Grundkörper der Kühleinrichtung beispielsweise das elektrische Massepotenzial der Vorrichtung aufweisen kann.

Die elektrische Isolierung zwischen dem Grundkörper der Kühleinrichtung und dem bandförmigen Substrat in Form der elektrisch isolierenden Randschicht der Kühleinrichtung sowie die elektrische Spannung zwischen dem Grundkörper der Kühleinrichtung und dem elektrisch leitfähigen Material des bandförmigen Substrates bewirken, dass elektrostatische Anziehungskräfte zwischen dem bandförmigen Substrat und der Kühleinrichtung ausgebildet werden können, wodurch ein höherer Anpressdruck des Substrates an die Kühlreinrichtung und infolgedessen eine verbesserte Kühlung und eine verminderte Faltenbildung des Substrates bewirkt werden.

Dabei werden die elektrostatischen Anziehungskräfte umso größer ausgebildet, je geringer die Schichtdicke der elektrisch isolierenden Randschicht des Kühlkörpers und je höher die relative Permittivität des Materials der elektrisch isolierenden Randschicht des Kühlkörpers gewählt wird. Beide Parameter können jedoch nicht beliebig ausgereizt werden, weil es ansonsten zu elektrischen Durchschlägen durch die elektrisch isolierende Randschicht des Kühlkörpers kommt. Vorteilhaft ist es aber, wenn ein Material für die elektrisch isolierende Randschicht des Kühlkörpers gewählt wird, dessen relative Permittivität größer als 2,5 ist.

Die elektrisch isolierende äußere Randschicht des Kühlkörpers kann ausgebildet werden, indem beispielsweise eine Kunststofffolie auf den elektrisch leitfähigen Grundkörper der Kühleinrichtung aufgeklebt wird. Dabei kann die Kunststofffolie zum Beispiel aus Polyethylentherephthalat (PET), Polypropylen (PP), Polyimid (PI) oder Polyetheretherketon (PEEK) bestehen und bevorzugt eine Dicke von 3 µm bis 50 µm aufweisen.

Alternativ kann auch eine Schicht aus einem elektrisch isolierenden Material auf dem elektrisch leitfähigen Grundkörper der Kühleinrichtung abgeschieden werden. Als Schichtmaterial hierfür kann beispielsweise ein Material verwendet werden, welches ein Oxid, Nitrid oder Carbid, mindestens eines der Elemente aus der Gruppe Aluminium, Silizium, Wolfram und Titan umfasst und welches bevorzugt mit einer Schichtdicke von 3 µm bis 10 µm auf dem elektrisch leitfähigen Grundkörper der Kühleinrichtung abgeschieden wird.

Auch für das Ausbilden einer elektrischen Spannung von mindestens 10 V zwischen dem elektrisch leitfähigen Grundkörper der Kühleinrichtung und dem elektrisch leitfähigen Material des Substrates sind verschiedene Ausgestaltungsvarianten möglich. So kann beispielsweise mittels einer Stromversorgungseinrichtung eine Spannung von mindestens 10 V zwischen dem elektrisch leitfähigen Grundkörper der Kühleinrichtung und einer Rolle des Wickelwerkes erzeugt werden, wobei hierbei eine Rolle des Wickelwerkes verwendet werden muss, die mit dem elektrisch leitfähigen Material des Substrates in Kontakt gelangt. Dabei ist es unerheblich, ob diese Rolle vor oder nach der Beschichtungseinrichtung angeordnet ist.

Alternativ kann aber auch eine Elektronenquelle, wie beispielsweise ein Elektronenstrahlerzeuger verwendet werden, von welchem beschleunigte Elektronen zum elektrisch leitfähigen Material des Substrates hin ausgesendet werden, um eine elektrische Aufladung des elektrisch leitfähigen Materials des Substrates zu erzeugen, infolgedessen eine elektrische Spannung zwischen dem elektrisch leitfähigen Grundkörper der Kühleinrichtung und dem elektrisch leitfähigen Material des Substrates ausgebildet wird.

Bei einer bevorzugten Ausführungsform wird das Material, welches auf dem bandförmigen Substrat abgeschieden werden soll, mittels eines Elektronenstrahlerzeugers verdampft. Die dabei vom Verdampfungsmaterial rückgestreuten Primärelektronen, welche auch das zu beschichtende bandförmige Substrat durchdringen, sind hinreichend, eine elektrische Aufladung des elektrisch leitfähigen Materials des bandförmigen Substrates und somit das Ausbildern einer elektrischen Spannung von mindestens 10 V zwischen dem elektrisch leitfähigen Grundkörper der Kühleinrichtung und dem elektrisch leitfähigen Material des Substrates zu bewirken.

Die Erfindung wird nachfolgend anhand von Ausführungsbeispielen näher beschrieben. Die Fig. zeigen:
- Fig. 1: eine schematische Schnittdarstellung einer erfindungsgemäßen Vorrichtung;
- Fig. 2: eine schematische Schnittdarstellung einer alternativen erfindungsgemäßen Vorrichtung.

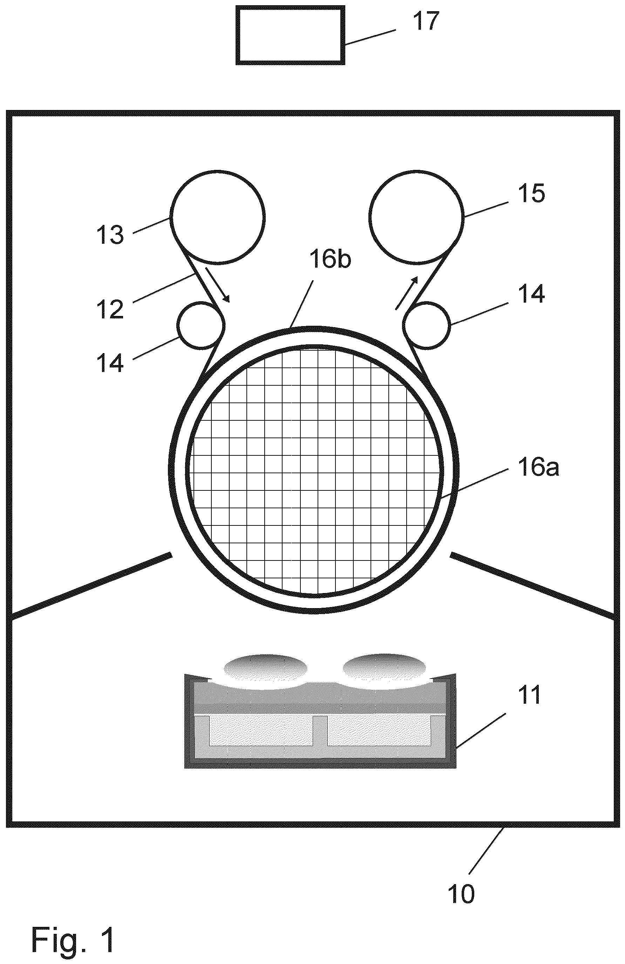

In Fig. 1 ist eine erfindungsgemäße Vorrichtung schematisch dargestellt, welche eine Vakuumkammer 10 umfasst. Innerhalb der Vakuumkammer 10 befindet sich eine als Magnetronsputtereinrichtung ausgebildete Beschichtungseinrichtung 11, mittels der ein als Metallfolie ausgebildetes bandförmiges Substrat 12 beschichtet werden soll. Dazu wird das bandförmige Substrat 12 zunächst von einer Vorratsrolle 13 abgewickelt, an einer Umlenkrolle 14 aus einem elektrisch leitfähigen Material vorbeigeführt und umschlingt dann eine als Kühlwalze ausgebildete Kühleinrichtung teilweise, welche das bandförmige Substrat 12 während der Schichtabscheidung mittels der Beschichtungseinrichtung 11 kühlt. Nach dem Verlassen der Kühleinrichtung wird das bandförmige Substrat 12 erneut an einer Umlenkrolle 14 vorbeigeführt und schließlich auf einer Aufnahmerolle 15 aufgewickelt.

Die als Kühlwalze ausgebildete Kühleinrichtung umfasst einen walzenförmigen Grundkörper 16a aus einem elektrisch leitfähigen Material und eine äußere Randschicht 16b aus einem elektrisch isolierenden Material an der konvexen Mantelfläche des walzenförmigen Grundkörpers 16a. Die äußere Randschicht 16b weist somit die Form eines Hohlzylinders auf und ist mit einer relativen Permittivität größer als 2,5 ausgebildet.

Die Vorratsrolle 13, die Aufnahmerolle 15 und die Umlenkrollen 14 bilden das Wickelwerk der erfindungsgemäßen Vorrichtung aus Fig. 1. Während der Grundkörper 16a der Kühleinrichtung das elektrische Massepotenzial der Vorrichtung aus Fig. 1 aufweist, ist das gesamte Wickelwerk potenzialfrei ausgebildet und weist somit keine elektrisch leitfähige Verbindung zum elektrischen Massepotenzial der Vorrichtung auf.

Ebenfalls zur erfindungsgemäßen Vorrichtung aus Fig. 1 gehört eine außerhalb der Vakuumkammer 10 angeordnete Stromversorgungseinrichtung 17, welche eine elektrische Spannung von etwa 1000 V zwischen dem elektrisch leitfähigen Grundkörper 16a der Kühleinrichtung und mindestens einer der Umlenkrollen 14 erzeugt. Dabei kann die Kontaktierung der drehbar gelagerten Umlenkrolle 14 und dem drehbar gelagerten Grundkörper 16a der Kühleinrichtung beispielsweise mit Schleifkontakten realisiert werden. Da das als Metallfolie ausgebildete bandförmige Substrat 12 die spannungsgeladene Umlenkrolle 14 berührt, wird auch die von der Stromversorgungseinrichtung 17 bereitgestellte elektrische Spannung zwischen dem bandförmigen Substrat und dem Grundkörper 16a der Kühleinrichtung ausgebildet. Die elektrisch isolierende Randschicht 16b der Kühleinrichtung zwischen dem bandförmigen Substrat 12 und dem elektrisch leitfähigen Grundkörper 16a bewirkt das Ausbilden elektrostatischer Kräfte, welche das bandförmige Substrat 12 an die Kühleinrichtung pressen. Dadurch wird zum einen eine bessere Kühlwirkung erzielt und zum anderen die Neigung des bandförmigen Substrates zur Faltenbildung an der Kühleinrichtung verringert.

Damit es nicht zu elektrischen Überschlägen an den seitlichen Rändern der zylinderförmigen Kühleinrichtung kommt, ist es vorteilhaft, wenn die Längsausdehnung der als Hohlzylinder ausgebildeten Randschicht 16b größer ist als die Längsausdehnung des zylinderförmigen Grundkörpers 16a, so dass die Randschicht 16b an beiden Seiten des zylinderförmigen Grundkörpers 16a über den zylinderförmigen Grundkörper 16a hinausragt. Wie groß ein solcher seitlicher Überstand der Randschicht 16b sein muss, um seitliche Überschläge zu verhindern, hängt unter anderem vom verwendeten Material für die Randschicht 16b, der Randschichtdicke und der Höhe der durch die Stromversorgung 17 bereitgestellten elektrischen Spannung ab. Ein exakter Wert für einen minimal erforderlichen Überstand lässt sich anhand des Paschen-Gesetzes ermitteln. Ein seitlicher Überstand von jeweils 1 cm sollte für die meisten Anwendungsfälle hinreichend sein.

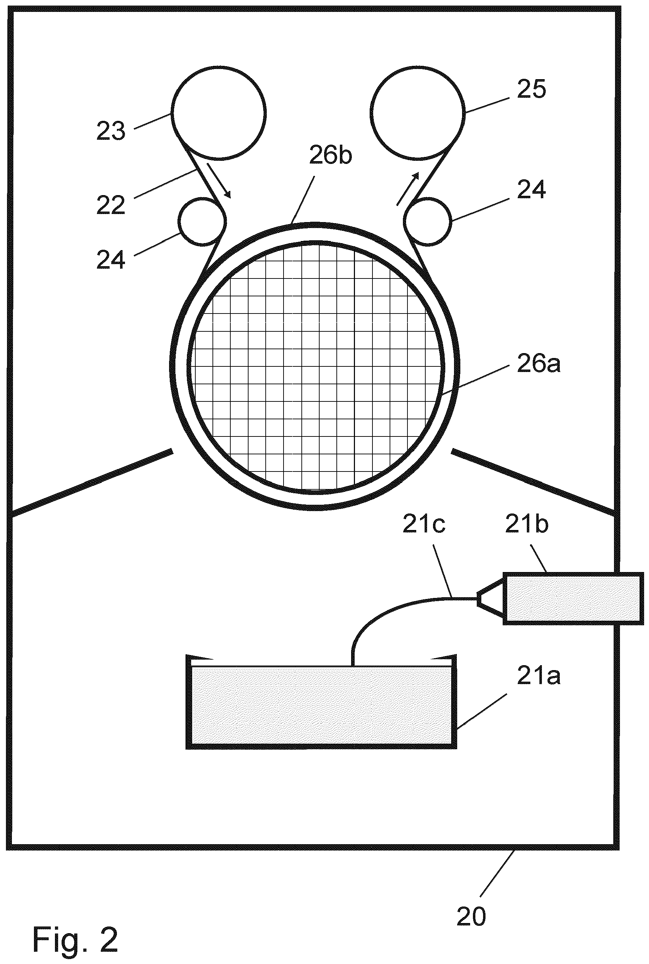

In Fig. 2 ist eine alternative erfindungsgemäße Vorrichtung schematisch dargestellt, welche eine Vakuumkammer 20 umfasst. Innerhalb der Vakuumkammer 20 befindet sich eine Beschichtungseinrichtung, mittels der ein bandförmiges Substrat 22 beschichtet werden soll. Die Beschichtungseinrichtung umfasst einen Tiegel 21a mit Verdampfungsmaterial, welches auf dem bandförmigen Substrat abgeschieden werden soll sowie einen Elektronenstrahlerzeuger 21b, zum Erzeugen eines Elektronenstrahls 21c, mit welchem das Verdampfungsmaterial verdampft wird.

Das bandförmige Substrat 22 ist als Kunststofffolie ausgebildet, welche bereits auf der Rückseite eine Schicht aus einem elektrisch leitfähigen Material aufweist. Das bandförmige Substrat 22 wird zunächst von einer Vorratsrolle 23 abgewickelt, an einer Umlenkrolle 24 aus einem elektrisch leitfähigen Material vorbeigeführt und umschlingt dann eine als Kühlwalze ausgebildete Kühleinrichtung teilweise, welche das bandförmige Substrat 22 während der Schichtabscheidung kühlt. Nach dem Verlassen der Kühleinrichtung wird das bandförmige Substrat 22 erneut an einer Umlenkrolle 24 vorbeigeführt und schließlich auf einer Aufnahmerolle 25 aufgewickelt.

Die als Kühlwalze ausgebildete Kühleinrichtung umfasst einen walzenförmigen Grundkörper 26a aus einem elektrisch leitfähigen Material und eine äußere Randschicht 26b aus einem elektrisch isolierenden Material an der konvexen Mantelfläche des walzenförmigen Grundkörpers 26a. Die äußere Randschicht 26b weist somit die Form eines Hohlzylinders auf und ist mit einer relativen Permittivität größer als 2,5 ausgebildet.

Die Vorratsrolle 23, die Aufnahmerolle 25 und die Umlenkrollen 24 bilden das Wickelwerk der erfindungsgemäßen Vorrichtung aus Fig. 2. Während der Grundkörper 26a der Kühleinrichtung das elektrische Massepotenzial der Vorrichtung aus Fig. 2 aufweist, ist das gesamte Wickelwerk potenzialfrei ausgebildet und weist somit keine elektrisch leitfähige Verbindung zum elektrischen Massepotenzial der Vorrichtung auf.

Beim Verdampfen des Verdampfungsmaterials im Tiegel 21a mittels des Elektronenstrahls 21c werden Elektronen vom Verdampfungsmaterial rückgestreut, welche auch das zu beschichtende bandförmige Substrat 22 durchdringen und dabei die elektrisch leitfähige Schicht auf der Rückseite des bandförmigen Substrates 22 aufladen. Aufgrund der elektrisch isolierenden Randschicht 26b der Kühleinrichtung zwischen dem bandförmigen Substrat 22 und dem elektrisch leitfähigen Grundkörper 26a wird somit eine elektrische Spannung von mehreren hundert bis mehreren tausend Volt zwischen dem bandförmigen Substrat 22 und dem elektrisch leitfähigen Grundkörper 26a erzeugt, welche das Ausbilden elektrostatischer Kräfte bewirkt, die das bandförmige Substrat 22 an die Kühleinrichtung pressen. Dadurch wird zum einen eine bessere Kühlwirkung erzielt und zum anderen die Neigung des bandförmigen Substrates 22 zur Faltenbildung an der Kühleinrichtung verringert.

Damit es nicht zu elektrischen Überschlägen an den seitlichen Rändern der zylinderförmigen Kühleinrichtung kommt, ist es auch bei diesem Ausführungsbeispiel vorteilhaft, wenn die Längsausdehnung der als Hohlzylinder ausgebildeten Randschicht 26b größer ist als die Längsausdehnung des zylinderförmigen Grundkörpers 26a, so dass die Randschicht 26b an beiden Seiten des zylinderförmigen Grundkörpers 26a über den zylinderförmigen Grundkörper 26a hinausragt.

## Patentansprüche

1. Vorrichtung zum Beschichten eines bandförmigen Substrates (12; 22) innerhalb einer Vakuumkammer (10; 20), umfassend eine Beschichtungseinrichtung (11); eine Kühleinrichtung mit zumindest einem konvexen Oberflächenbereich, welchen das bandförmige Substrat (12; 22) zum Zeitpunkt des Beschichtens zumindest teilweise berührt sowie ein Wickelwerk, mindestens bestehend aus einer Vorratsrolle (13; 23), einer Aufnahmerolle (15; 25) und mehreren Umlenkrollen (14; 24), wobei das bandförmige Substrat (12; 22) zumindest an der Seite, mit welcher das bandförmige Substrat (12; 22) die Kühleinrichtung berührt, aus einem elektrisch leitfähigen Material besteht **dadurch gekennzeichnet, dass**
a) die Kühleinrichtung einen elektrisch leitfähigen Grundkörper (16a; 26a) und zumindest im konvexen Oberflächenbereich eine äußere Randschicht (16b; 26b) aus einem elektrisch isolierenden Material aufweist;
b) das Wickelwerk potenzialfrei bezüglich der elektrischen Masse der Vorrichtung ausgebildet ist und
c) eine elektrische Spannung von mindestens 10 V zwischen dem elektrisch leitfähigen Grundkörper (16a; 26a) der Kühleinrichtung und dem elektrisch leitfähigen Material des Substrates (12; 22) ausgebildet ist.

2. Vorrichtung nach Anspruch 1, **dadurch gekennzeichnet, dass** die äußere Randschicht (16b; 26b) der Kühleinrichtung eine relative Permittivität größer als 2,5 aufweist.

3. Vorrichtung nach Anspruch 1 oder 2, **dadurch gekennzeichnet, dass** die äußere Randschicht der Kühleinrichtung als, auf den elektrisch leitfähigen Grundkörper aufgeklebte, Kunststofffolie ausgebildet ist.

4. Vorrichtung nach Anspruch 3, **dadurch gekennzeichnet, dass** die Kunststofffolie aus Polyethylentherephthalat, Polypropylen, Polyimid oder Polyetheretherketon besteht.

5. Vorrichtung nach Anspruch 3 oder 4, **dadurch gekennzeichnet, dass** die Kunststofffolie eine Dicke von 3 µm bis 50 µm aufweist.

6. Vorrichtung nach Anspruch 1 oder 2, **dadurch gekennzeichnet, dass** der elektrisch leitfähige Grundkörper der Kühleinrichtung mit einem elektrisch isolierenden Material beschichtet ist.

7. Vorrichtung nach Anspruch 6, **dadurch gekennzeichnet, dass** das elektrisch isolierende Material ein Oxid, Nitrid oder Carbid, mindestens eines der Elemente aus der Gruppe Aluminium, Silizium, Wolfram und Titan umfasst.

8. Vorrichtung nach Anspruch 6 oder 7, **dadurch gekennzeichnet, dass** das elektrisch isolierende Material eine Schichtdicke von 3 µm bis 10 µm aufweist.

9. Vorrichtung nach einem der Ansprüche 1 bis 8, **gekennzeichnet durch** eine Stromversorgung (17), mittels welcher eine elektrische Spannung von mindestens 10 V zwischen dem elektrisch leitfähigen Grundkörper (16a) der Kühleinrichtung und mindestens einer Rolle (14) des Wickelwerkes erzeugbar ist.

10. Vorrichtung nach einem der Ansprüche 1 bis 8, **gekennzeichnet durch** einen Elektronenstrahlgenerator, mittels dem das elektrisch leitfähige Material des bandförmigen Substrates mit beschleunigten Elektronen beaufschlagbar ist.

11. Vorrichtung nach einem der Ansprüche 1 bis 8, **gekennzeichnet durch** einen Elektronenstrahlgenerator (21b) zum Erzeugen eines Elektronenstrahls (21c), mittels dem ein Beschichtungsmaterial verdampfbar ist, wobei vom Beschichtungsmaterial rückgestreute Elektronen das bandförmige Substrat (22) durchdringen.
